Europäisches Patentamt

European Patent Office

Office européen des brevets

(19)

(11) EP 0 575 227 B1

(12) **FASCICULE DE BREVET EUROPEEN**

(45) Date de publication et mention
de la délivrance du brevet:
**12.02.1997 Bulletin 1997/07**

(51) Int Cl.6: **G02F 1/01**, H01S 3/085,
H01S 3/094, H01S 3/103,
H01S 3/25

(21) Numéro de dépôt: **93401496.0**

(22) Date de dépôt: **11.06.1993**

(54) **Procédé et dispositif de modulation et d'amplification de faisceaux lumineux**

Verfahren und Vorrichtung zur Modulation und Verstärkung von Lichtstrahlen

Process and apparatus for the modulation and amplification of lightrays

(84) Etats contractants désignés:
**DE GB**

(30) Priorité: **15.06.1992 FR 9207182**

(43) Date de publication de la demande:
**22.12.1993 Bulletin 1993/51**

(73) Titulaire: **FRANCE TELECOM**
**75015 Paris (FR)**

(72) Inventeurs:
• **Raj, Rama**
**F-75005 Paris (FR)**
• **Bensoussan, Marcel**
**F-92100 Boulogne (FR)**
• **Oudar, Jean-Louis**
**F-92290 Chatenay-Malabry (FR)**
• **Levenson, Juan-Ariel**
**F-75014 Paris (FR)**

(74) Mandataire: **Dubois-Chabert, Guy et al**
**Société de Protection des Inventions**
**25, rue de Ponthieu**
**75008 Paris (FR)**

(56) Documents cités:
**EP-A- 0 155 802** **EP-A- 0 384 764**
**WO-A-84/03397**

• **PATENT ABSTRACTS OF JAPAN vol. 12, no. 407
(E-675)27 Octobre 1988; & JP-A-63148687**
• **PATENT ABSTRACTS OF JAPAN vol. 16, no. 252
(P-1367)9 Juin 1992; & JP-A-04060522**
• **PROCEEDINGS OF THE CONFERENCE ON
PHISICAL CONCEPTS OF MATERIALS FOR
NOVEL OPTOELECTRONIC DEVICE,
APPLICATIONS II: DEVICE PHYSICS AND
APPLICATIONS Octobre 1990, AACHEN,
GERMANY pages 24 - 37 L.A. COLDREN ET AL
'High efficeincy vertical cavity lasers and
modulators'**
• **APPLIED PHYSICS LETTERS. vol. 55, no. 18, 30
Octobre 1989, NEW YORK US pages 1817 - 1819
A. TOMITA ET AL '5:1 ON-OFF contrast
InGaAs/InP multiple quantum well fabry-perot
etalon modulator'**

## Description

La présente invention concerne un procédé et un dispositif de modulation et d'amplification de faisceaux lumineux.

Elle s'applique notamment au traitement de signaux optiques pour les télécommunications optiques, pour les interconnexions optiques "intra-chip" et "inter-chip" et pour les réseaux neuronaux.

Les dispositifs photoniques à structure multicouche, avec accès perpendiculaire aux couches, qui sont appelés couramment "structures verticales", constituent l'une des approches techniques les mieux adaptées pour exploiter le parallélisme et pour tirer le meilleur parti des très hauts débits que permettent les liaisons optiques.

Une nouvelle classe de composants fondée sur la mise en oeuvre d'une cavité verticale de Fabry-Perot a récemment été développée dans des semiconducteurs III-V pour réaliser :

- des lasers (voir les documents (1) et (2) qui comme les autres documents cités par la suite, sont mentionnés à la fin de la présente description),
- des thyristors optiques (voir le document (3)),
- des bistables (voir le document (4)),et
- des modulateurs (voir les documents (5) et (6)),
- des portes optiques (voir le document (6)).

Dans la plupart de ces structures, le miroir-avant et le miroir-arrière de la cavité sont constitués d'empilements multicouches périodiques "quart d'onde" de façon à obtenir la réflectivité optimale nécessaire au fonctionnement des dispositifs.

La grande majorité des modulateurs connus de ce type exploitent l'effet d'électro-absorption lié à l'effet Stark dans des multipuits quantiques ou à l'effet Wannier-Stark dans des super-réseaux, à savoir les variations de l'absorption optique induites par un champ électrique.

Il s'agit donc de modulateurs à commande électrique (voir le document (5)).

On connaît également des modulateurs à structure multicouche de type Fabry-Perot dits "tout optique", où les variations de l'absorption optique sont induites par un faisceau optique de commande (voir le document (6)).

On connaît également des modulateurs intégrant une structure multicouche de type Fabry-Perrot et un phototransistor à hétérojonction capable de faire commuter un faisceau optique au moyen d'un autre faisceau optique d'intensité plus faible, le gain étant fourni par le phototransistor (voir le document (7)).

Les modulateurs qui présentent actuellement les meilleures performances notamment du point de vue du contraste entre état "éteint" et état "allumé" sont ceux qui mettent à profit la conjonction des variations de l'absorption optique induite électriquement ou optiquement et les résonances dans une cavité de Fabry-Perot entourant un milieu actif.

Les caractéristiques de la cavité (réflectivité du miroir-avant et du miroir-arrière et taille de cette cavité) sont calculées de manière à ce que la réflectivité dans l'état "éteint" soit quasiment nulle.

Dans l'état "allumé", la réflectivité n'est pas nulle mais n'atteint jamais 100%, ce qui conduit à une atténuation prohibitive du faisceau à moduler, encore appelée "perte d'insertion", introduite par le modulateur.

La présente invention a pour but de remédier à cet inconvénient en associant dans un même dispositif et simultanément une fonction d'amplification optique et une fonction de modulation du faisceau d'entrée, éliminant ainsi les pertes d'insertion liées au dispositif tout en conservant un bon contraste entre les états "éteint" et "allumé".

La présente invention a pour objet un procédé de modulation conformément à la revendication 1.

Dans le cas où la cavité est multimode, on peut utiliser une pluralité de faisceaux d'entrée de longueurs d'ondes différentes, chaque longueur d'onde étant choisie autour de l'une des résonances de la cavité.

Selon un mode de mise en oeuvre particulier du procédé objet de l'invention, l'empilement de couches inclut au moins une jonction P-N et on polarise celle-ci de façon directe tout en faisant varier cette polarisation de manière à injecter des porteurs de charge libres et à obtenir la variation de la densité de porteurs de charge libres dans le milieu actif.

Selon un autre mode de mise en oeuvre particulier, on envoie en outre un faisceau lumineux de commande dans le milieu actif, ce faisceau lumineux de commande étant apte à être absorbé par ce milieu actif et à réaliser un pompage optique dans ce dernier, et on fait varier l'intensité du faisceau lumineux de commande de manière à obtenir la variation de la densité de porteurs de charge libres dans le milieu actif.

Selon un autre mode de mise en oeuvre particulier, la longueur d'onde de chaque faisceau d'entrée correspond à la résonance de la cavité dans l'état éteint (ou à l'une des résonances de la cavité dans l'état éteint lorsque cette cavité est multimode).

Ceci permet un taux d'extinction maximum dans le cas d'une utilisation de la cavité en mode réflexion, mode dans lequel le faisceau de sortie est le faisceau d'entrée réfléchi sur l'un des miroirs de la cavité.

Selon un autre mode de mise en oeuvre particulier, la longueur d'onde de chaque faisceau d'entrée correspond à la résonance de la cavité dans l'état allumé.

Ceci permet, dans le cas d'une utilisation de la cavité en mode réflexion, de profiter du gain maximum disponible.

Selon un autre mode de mise en oeuvre particulier, on établit dans le milieu actif un régime d'injection électrique ou de pompage optique stationnaire, et on agit simultanément sur le milieu actif de manière à réaliser une commutation de gain pour obtenir la modulation du ou des faisceaux lumineux de sortie.

Le milieu actif peut être excité de manière à obtenir une émission laser de sa part ; dans ce cas il y a avantage à ce que chaque faisceau lumineux d'entrée ait un angle d'incidence non nul sur l'un des miroirs du résonateur de manière à ce que l'émission laser ne perturbe pas la détection du ou des faisceaux de sortie.

On peut envoyer une pluralité de faisceaux lumineux d'entrée sur le résonateur, ces faisceaux lumineux d'entrée ayant des directions d'incidence différentes sur l'un des miroirs du résonateur et des longueurs d'onde identiques ou différentes, chaque longueur d'onde étant choisie soit autour d'une même résonance de la cavité soit autour de différentes résonances de la cavité si celle-ci est multimode.

On peut ainsi appliquer la même modulation à cette pluralité de faisceaux qui seront distingués soit par leur direction de sortie soit par leur longueur d'onde.

On peut envoyer une pluralité de faisceaux d'entrée respectivement sur une pluralité de résonateurs de Fabry-Perot formant un réseau bidimensionnel sur un même substrat, de manière à obtenir une pluralité de faisceaux de sortie modulés et amplifiés.

Ces résonateurs peuvent être identiques les uns aux autres quant à leurs caractéristiques ou avoir des caractéristiques différentes.

La présente invention a également pour objet un dispositif de modulation d'au moins un faisceau lumineux, conformément à la revendication 12.

Le dispositif objet de l'invention présente une certaine analogie dans son principe avec l'utilisation des amplificateurs à semiconducteurs à "cavité horizontale" comme modulateurs de lumière (voir les documents (8) et (9)).

Dans ces dispositifs connus, on peut en effet obtenir la modulation d'une intensité lumineuse en faisant varier le caractère absorbant ou amplificateur d'une couche active, par modification de la densité de porteurs dans cette couche active.

Cependant, le dispositif objet de l'invention présente par rapport à ces amplificateurs-modulateurs à semiconducteurs connus, quatre avantages essentiels qui sont indiqués dans ce qui suit.

1° Lorsqu'il est employé à incidence normale, le dispositif objet de l'invention est insensible à la polarisation.

Ceci est particulièrement important pour moduler des signaux qui ont été soit transmis par une fibre optique, et dont l'état de polarisation varie en général au cours du temps, soit émis par une source-laser fortement polarisée.

2° Le dispositif objet de l'invention comporte une cavité de Fabry-Perot, ce que l'on cherche à éviter dans ces amplificateurs-modulateurs connus en déposant sur ceux-ci des couches antireflets.

En raison de l'existence de cette cavité de Fabry-Perot dans le dispositif objet de l'invention, le caractère amplificateur du milieu actif qu'il comporte peut donner lieu à une émission laser, ce qui est d'ailleurs mis à profit dans certains modes de réalisation de ce dispositif.

3° La propagation de la lumière dans le dispositif objet de l'invention est très différente de la propagation de la lumière dans ces amplificateurs-modulateurs connus.

En effet, dans un dispositif du genre de ces derniers, la lumière se propage dans un guide d'onde dont l'axe est parallèle au substrat sur lequel est formé ce dispositif.

Ce guide d'onde est en général monomode transverse, ce qui entraine que le faisceau de sortie ne peut avoir qu'une seule direction.

Dans le dispositif objet de l'invention, le ou les faisceaux d'entrée et le ou les faisceaux de sortie sont dirigés perpendiculairement aux couches ou obliquement à ces dernières.

De plus, la faible longueur de la cavité du dispositif objet de l'invention (faible longueur qui est liée à la faible épaisseur des couches de ce dispositif) fait que les modes de la cavité sont très espacés dans le domaine spectral et qu'ils possèdent une largeur naturelle relativement grande.

Cette largeur spectrale s'accompagne d'une acceptance angulaire assez élevée, ce qui procure une souplesse d'emploi nettement plus grande que dans le cas d'une cavité de grande longueur.

Par exemple, une micro-cavité dont la couche active a une longueur de 0,36 micromètre possède une tolérance angulaire supérieure à 5° au voisinage de l'incidence normale.

Il est donc facile d'envoyer le ou les faisceaux d'entrée suivant une incidence oblique et de récupérer en réflexion oblique le ou les faisceaux de sortie amplifiés et modulés.

La tolérance angulaire permet en particulier l'amplification d'images : on peut envoyer sur un dispositif conforme à l'invention, par l'intermédiaire d'une optique appropriée, plusieurs faisceaux lumineux respectivement issus de plusieurs fibres optiques et correspondant respectivement à des pixels d'une même image, pour obtenir des faisceaux amplifiés et donc une image amplifiée.

4° La taille et la structure "verticale" de microrésonateurs conformes à l'invention sont des atouts essentiels pour réaliser des matrices bidimensionnelles, avec une densité d'intégration très élevée, ce qui ne peut pas être le cas des amplificateurs-modulateurs connus, mentionnés plus haut.

Selon un mode de réalisation particulier du dispositif objet de l'invention, le milieu actif se trouve dans l'un des miroirs du résonateur ou dans les deux.

Selon un autre mode de réalisation particulier, le milieu actif se trouve entre les deux miroirs du résonateur.

Dans ce cas, le dispositif peut comporter au moins une jonction P-N et les moyens prévus pour faire varier la densité de porteurs de charge libres dans le milieu actif peuvent être des moyens aptes à polariser de façon directe cette jonction et à faire varier cette polarisation de façon à obtenir la modulation du ou des faisceaux de sortie.

Le substrat du dispositif peut être transparent au(x) faisceau(x) lumineux d'entrée, de sorte que ce dispositif est utilisable en transmission ou en réflexion à travers ce substrat.

Si le substrat est absorbant vis-à-vis du ou des faisceaux lumineux d'entrée, ce substrat peut comporter une ou des ouvertures permettant l'utilisation du dispositif en transmission ou en réflexion.

Dans tous les cas, la face libre du miroir-avant, miroir qui reçoit le ou les faisceaux lumineux d'entrée, peut constituer aussi la face de sortie du ou des faisceaux lumineux de sortie, le dispositif fonctionnant ainsi en réflexion.

Dans ce cas de fonctionnement en réflexion, selon un mode de réalisation particulier, la longueur d'onde du faisceau lumineux d'entrée est un mode de résonance du résonateur du dispositif et la réflectivité de ce miroir est inférieure à la réflectivité de l'autre miroir du dispositif.

Egalement dans ce cas de fonctionnement en réflexion, selon un autre mode de réalisation particulier, la longueur d'onde du faisceau lumineux d'entrée est un mode de résonance du résonateur du dispositif et la réflectivité dudit miroir est supérieure ou égale à la réflectivité de l'autre miroir du dispositif.

Le dispositif objet de l'invention peut comprendre une pluralité de résonateurs de type Fabry-Perot, formant un réseau bidimensionnel sur un même substrat.

Le dispositif peut être réalisé à partir de matériaux semiconducteurs III-V, ce qui permet une intégration micro-opto-électronique avec des dispositifs de fonctionnalité complémentaire.

Enfin, l'un au moins des miroirs peut être une multicouche diélectrique dont l'épaisseur n'a pas besoin d'être aussi élevée que celle d'un miroir de Bragg réalisé avec des matériaux III-V compte tenu des possibilités de valeurs très différentes d'indice offertes par les diélectriques.

La présente invention sera mieux comprise à la lecture de la description d'exemples de réalisation donnés ci-après à titre purement indicatif et nullement limitatif, en faisant référence aux dessins annexés sur lesquels :

- la figure 1 est une vue schématique et partielle d'un dispositif conforme à l'invention,
- la figure 2 est une vue schématique d'un mode de réalisation particulier du dispositif objet de l'invention, comportant des moyens de commande électrique,
- la figure 3 est une vue schématique d'un autre mode de réalisation particulier du dispositif objet de l'invention, comportant des moyens de commande optique,
- la figure 4 illustre schématiquement la modulation de plusieurs faisceaux lumineux au moyen d'un seul dispositif conforme à l'invention,
- la figure 5 est une vue schématique d'une matrice de dispositifs conformes à l'invention,
- les figures 5A et 5B illustrent schématiquement des dispositifs conformes à l'invention dont les substrats comportent des ouvertures,
- la figure 6 est un graphique montrant les variations du coefficient d'absorption en fonction de l'énergie d'un photon incident pour deux valeurs de la densité de porteurs de charge libres dans le milieu actif d'un dispositif conforme à l'invention (à noter que lorsque l'absorption devient négative le milieu est amplificateur),
- la figure 7 est un graphique montrant les variations de la partie réelle de l'indice de réfraction de ce milieu actif en fonction de cette énergie du photon incident, pour ces deux valeurs de la densité de porteurs,
- les figures 8 et 9 montrent, pour une cavité de Fabry-Perot d'un dispositif conforme à l'invention dont le milieu actif se trouve entre les deux miroirs, les variations du coefficient de réflectivité de la cavité, en fonction d'un paramètre lié au déphasage introduit par cette cavité, pour diverses valeurs du coefficient d'absorption par unité de longueur, dans le cas où la réflectivité du miroir-arrière du dispositif est supérieure à la réflectivité du miroir-avant (figure 8) et dans le cas contraire (figure 9),
- les figures 10 et 11 montrent les variations de ce coefficient de réflectivité de la cavité en fonction de la densité de porteurs, pour diverses valeurs du déphasage introduit par la cavité, dans le cas où la réflectivité du miroir-arrière du dispositif est supérieure à celle du miroir-avant (figure 10) et dans le cas contraire (figure 11),
- la figure 12 montre de façon schématique et partielle un dispositif conforme à l'invention qui fournit en sortie un faisceau lumineux modulé et qui engendre aussi un faisceau laser non superposé à ce faisceau modulé,
- la figure 13 est une vue schématique et partielle d'un dispositif conforme à l'invention qui fonctionne en réflexion et qui utilise une commande optique,
- la figure 14 est une vue schématique et partielle d'un autre dispositif conforme à l'invention qui fonctionne en réflexion et qui utilise une commande électrique, et
- les figures 15 et 16 illustrent schématiquement des dispositifs conformes à l'invention dont le milieu actif se trouve dans l'un au moins des miroirs de la cavité.

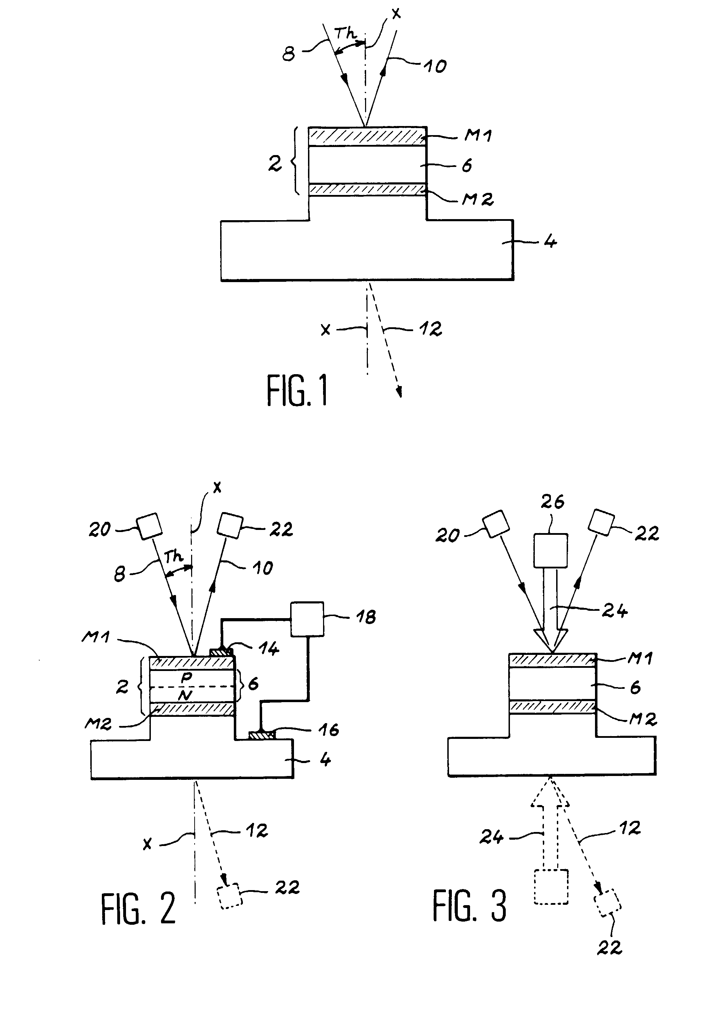

Sur la figure 1, on a représenté de façon schématique et partielle un dispositif conforme à l'invention.

Ce dispositif est un modulateur-amplificateur de lumière et comprend un résonateur 2, ou cavité, de type Fabry-Perot qui est réalisé par empilement de couches minces sur un substrat 4.

Ces couches minces peuvent être formées par épitaxie sur le substrat ou peuvent être rapportées sur ce dernier.

Certaines de ces couches sont des couches actives capables d'amplifier la lumière par émission stimulée.

La cavité 2 (que l'on peut également appeler microcavité compte tenu de la minceur des couches qui la constituent) est délimitée par un miroir-avant M1 (miroir par lequel le faisceau d'entrée accède au dispositif) et par un miroir-arrière M2.

L'ensemble des couches actives constitue un milieu actif, ou milieu amplificateur, qui peut être réparti soit dans l'ensemble du dispositif, soit dans l'un des miroirs de la cavité, soit dans les deux, soit entre ces miroirs, ce dernier cas étant représenté sur la figure 1 où le milieu actif porte la référence 6.

Le miroir-avant M1 est partiellement transparent pour laisser passer une partie d'un faisceau lumineux incident 8 que l'on veut moduler, appelé faisceau d'entrée.

Le dispositif de la figure 1 fournit un faisceau lumineux modulé et amplifié 10 appelé faisceau de sortie.

On voit sur la figure 1 que ce faisceau de sortie 10 émerge du miroir-avant M1 et que le dispositif fonctionne en réflexion.

Si le substrat 4 est transparent vis-à-vis du faisceau lumineux modulé et amplifié et si le miroir-arrière M2 est partiellement transparent vis-à-vis de ce faisceau modulé, le dispositif de la figure 1 est susceptible de travailler en transmission.

Dans ce cas, le faisceau modulé que l'on utilise est un faisceau 12 qui émerge de la face inférieure du substrat 4 (face opposée à celle qui porte le miroir M2).

La modulation et l'amplification de l'intensité du faisceau d'entrée sont obtenues en faisant varier la densité de porteurs de charge libres (électrons et trous) dans le milieu actif 6 de façon à modifier au cours du temps le caractère absorbant ou amplificateur de ce milieu actif 6 vis-à-vis de la lumière incidente.

La figure 2 illustre schématiquement un dispositif conforme à l'invention dont la commande est électrique.

Plus précisément, le dispositif de la figure 2 est conforme à celui de la figure 1, mais en plus, une jonction P-N est prévue dans le milieu actif 6.

Un contact électrique 14 est prévu sur la face supérieure du miroir M1 et un autre contact électrique 16 est prévu sur le substrat 4 (supposé capable de conduire un courant électrique).

Des moyens de commande 18, reliés aux contacts électriques 14 et 16, sont prévus pour polariser de façon directe la jonction P-N tout en faisant varier au cours du temps cette polarisation de manière à obtenir la modulation voulue.

Dans ce cas, l'injection des porteurs est réalisée par passage d'un courant électrique dans la jonction P-N.

On voit aussi sur la figure 2 un moyen 20 (fibre optique ou source lumineuse) d'où est issu le faisceau 8 que l'on veut moduler et un moyen 22 (fibre optique ou photo-détecteur) qui reçoit le faisceau modulé.

La figure 3 illustre schématiquement le cas où le dispositif décrit en faisant référence à la figure 1 est commandé par un faisceau lumineux 24.

Ce faisceau 24, issu d'une source appropriée 26, a une longueur d'onde telle qu'il puisse être absorbé par le milieu actif 6.

Le faisceau de commande 24 peut être envoyé dans le milieu actif 6 à travers le miroir M1 (qui est alors réalisé de façon à laisser passer au moins une partie du faisceau de commande 24).

Dans le cas où le substrat 4 et le miroir M2 sont aptes à laisser passer au moins une partie de ce faisceau de commande 24, ce dernier peut être envoyé dans le milieu actif 6 à travers le substrat 4 et le miroir M2.

Le faisceau de commande 24 est capable de provoquer un pompage optique dans le milieu actif 6 à la suite de son absorption par ce milieu.

De cette façon on fait encore varier la densité de porteurs dans le milieu actif 6.

La source 26 est prévue pour faire varier l'intensité du faisceau de commande 24 qu'elle émet de façon à moduler le faisceau de sortie de la façon souhaitée.

La rapidité avec laquelle on est capable de modifier la densité de porteurs dans le milieu actif est bien entendu une caractéristique importante, car elle gouverne la bande passante de modulation.

Le processus d'émission stimulée mis en oeuvre dans le dispositif de la figure 2 et dans le dispositif de la figure 3 permet d'accélérer la recombinaison des porteurs et donc d'obtenir une grande bande passante de modulation, qui peut être supérieure à 10 GHz.

Les longueurs d'ondes de fonctionnement d'un dispositif du genre de ceux des figures 2 et 3 sont déterminées par la taille de la cavité que comporte ce dispositif, par la constitution du miroir-avant et du miroir-arrière de cette cavité et par la nature du matériau constituant les couches actives formant le milieu actif du dispositif.

De plus, pour une cavité donnée, on peut ajuster les longueurs d'onde de fonctionnement autour de l'une des résonances de la cavité en faisant varier légèrement l'angle d'incidence Th du faisceau d'entrée 8.

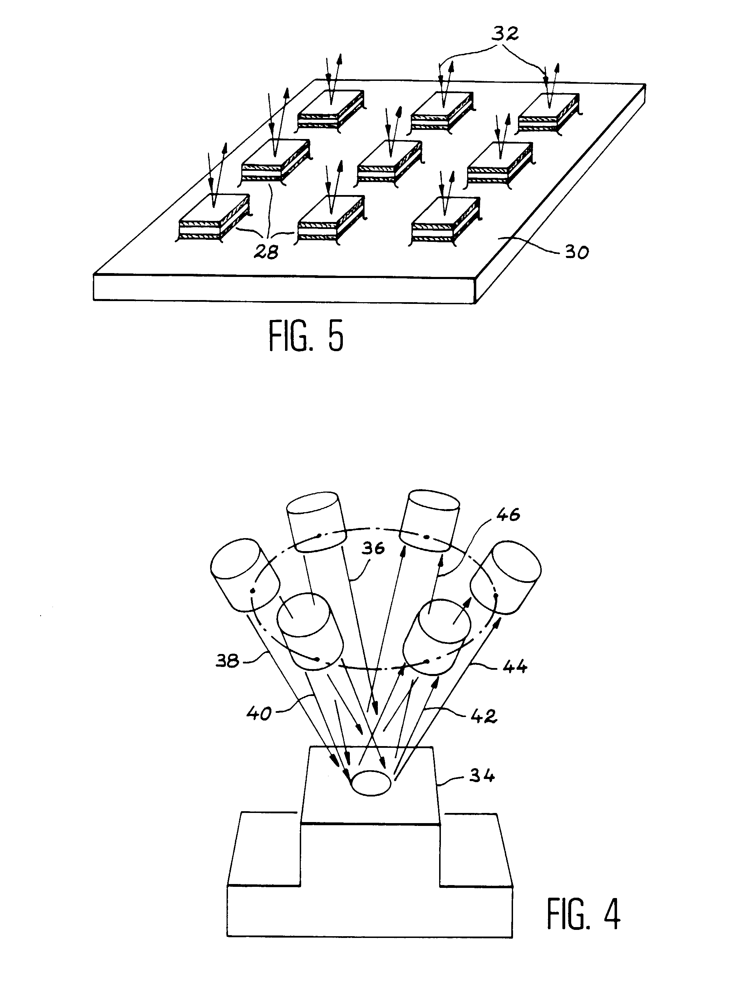

La figure 4 illustre schématiquement l'utilisation d'un même dispositif 34 conforme à l'invention pour moduler trois faisceaux lumineux d'entrée 36, 38 et 40.

Les faisceaux de sortie modulés correspondant aux faisceaux 36, 38 et 40 portent respectivement les références 42, 44 et 46 sur la figure 4.

Les faisceaux incidents 36, 38 et 40 peuvent avoir des longueurs d'onde identiques ou différentes, choisies parmi les modes de la cavité de Fabry-Perot du dispositif.

Dans le cas où les longueurs d'onde des faisceaux d'entrée sont identiques il est avantageux d'avoir le même angle d'incidence pour tous les faisceaux comme il est indiqué sur la figure 4.

Dans le cas où les longueurs d'onde des faisceaux d'entrée sont différentes il est possible pour maintenir des performances optimales vis-à-vis de chaque faisceau incident d'ajuster individuellement chaque angle d'incidence.

Du fait que l'axe X de la cavité est perpendiculaire au substrat 4, la structure des dispositifs des figures 1 à 4 se prête parfaitement à la réalisation de réseaux bidimensionnels de modulateurs.

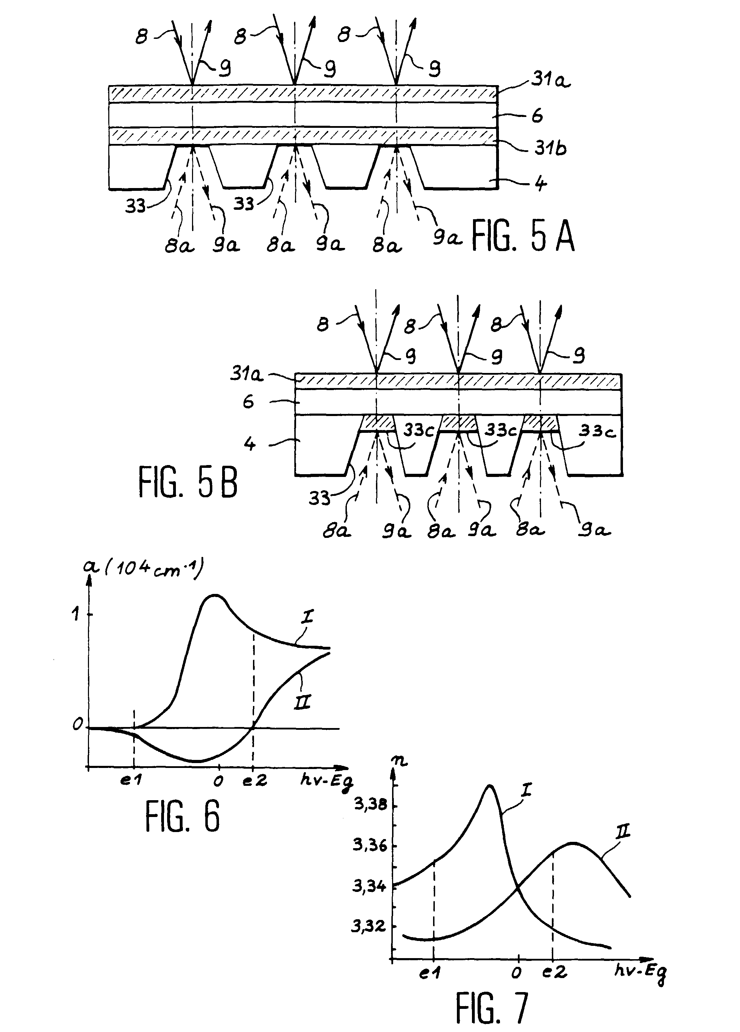

Ceci est illustré par la figure 5 sur laquelle on voit un réseau bidimensionnel de dispositifs 28 conformes à l'invention qui sont réalisés sur un même substrat 30 et qui sont capables de moduler en parallèle des faisceaux lumineux incidents 32.

Les différents modulateurs constituant ce réseau bidimentionnel peuvent être soit strictement identiques entre eux soit de caractéristiques différentes.

De tels réseaux bidimensionnels de modulateurs conformes à l'invention permettent d'exploiter le traitement de faisceaux lumineux (de longueurs d'onde identiques ou différentes) en parallèle permis par l'Optique, et donc d'augmenter la vitesse globale de traitement de signaux lumineux.

Les figures 5A et 5B illustrent schématiquement un dispositif conforme à l'invention comportant sur un substrat 4 dans lequel on a pratiqué des ouvertures 33, un milieu actif 6 compris entre deux miroirs 31a et 31b.

Chaque ouverture délimite un modulateur élémentaire qui peut fonctionner en mode réflexion ou en mode transmission et ceci que l'on prenne le miroir 31a ou le miroir 31b comme miroir-avant d'entrée.

Les faisceaux d'entrée sont référencés 8 ou 8a suivant que l'accès aux modulateurs se fait par le miroir 31a ou le miroir 31b.

Les faisceaux de sortie référencés 9 ou 9a apparaissent suivant que l'on travaille en mode réflexion ou en mode de transmission par rapport aux faisceaux d'entrée.

Dans le cas de la figure 5A, le miroir 31a, le milieu actif 6 et le miroir 31b sont d'abord déposés sur le substrat 4 dans lequel on pratique ensuite des ouvertures du côté opposé au dépôt, jusqu'à la mise à nu du miroir 31b.

Le mode de réalisation schématiquement représenté sur la figure 5B diffère de celui de la figure 5A par le fait que, dans le cas de la figure 5B, c'est le milieu actif 6 qui est en contact avec le substrat opaque 4, le miroir 31b étant alors en plusieurs morceaux 33a qui sont déposés au fond des ouvertures 33.

On détaille ci-après le cas où le milieu actif est inséré dans la cavité de Fabry-Perot d'un dispositif conforme à l'invention.

Dans ce cas, les caractéristiques de la modulation sont influencées par les paramètres de cette cavité, à savoir :

-   la réflectivité R1 du miroir-avant d'entrée M1 de la cavité,

-   la réflectivité R2 du miroir-arrière M2 de cette cavité,
-   l'épaisseur du milieu actif du dispositif, et
-   l'indice de réfraction complexe Nr de ce milieu actif.

La partie réelle $\underline{n}$ de cet indice de réfraction Nr gouverne la condition de résonance de la cavité.

La partie imaginaire K de cet indice de réfraction gouverne, suivant son signe, l'absorption ou l'amplification de lumière : si K est positif il y a absorption et si K est négatif il y a amplification.

L'indice de réfraction complexe Nr dépend de la densité de porteurs D injectés dans le milieu actif.

Un tel dispositif de modulation conforme à l'invention peut dans tous les cas être utilisé en réflexion.

On détaille ci-après le cas de la réflexion en raison de sa généralité et des performances que l'on y atteint.

Le coefficient de réflectivité R de la micro-cavité du dispositif conforme à l'invention utilisé en réflexion est donné par la formule suivante :

$$R = A/B \tag{1}$$

avec

$$A = (R1 - Ra)^2 /R1 + 4\, Ra.\sin^2 (phi)$$

et

$$B = (1 - Ra)^2 + 4\, Ra.\sin^2 (phi)$$

où

$$Ra = (R1.R2)^{1/2} \exp (-a.L/cosTh)$$

$$phi = 2pi.n.L.(cosTh)/l$$

$$a = 4\, pi.K/l.$$

Dans ce qui précède, $\underline{a}$ représente le coefficient d'aborption par unité de longueur, L représente la longueur de la micro-cavité (comptée parallèlement à l'axe X de cette cavité et donc perpendiculairement au substrat sur lequel elle est formée), Th représente l'angle d'incidence du faisceau d'entrée, phi représente le déphasage introduit par la cavité, $\underline{l}$ représente la longueur d'onde (dans le vide) du faisceau lumineux d'entrée et pi représente le nombre bien connu qui vaut approximativement 3,14.

Les quantités $\underline{n}$ et $\underline{a}$ dépendent de la densité de porteurs D dans le milieu actif ainsi que de la longueur d'onde $\underline{l}$.

Sur les figures 6 et 7 (inspirées du document (10)), on a représenté schématiquement, pour un milieu actif constitué d'une structure à puits quantiques, les variations de $\underline{a}$ (figure 6) et de $\underline{n}$ (figure 7) lorsque D est nulle (courbes I) et lorsque D est égale à $3 \times 10^{12}$ cm$^{-2}$ (courbes II), en fonction de la différence h.v-Eg entre l'énergie h.v d'un photon incident et l'énergie Eg de la bande interdite des couches actives constituant le milieu actif.

La figure 6 montre qu'il existe toute une gamme spectrale comprise entre deux valeurs e1 et e2 de h.v-Eg où l'on a de l'absorption ou du gain suivant le taux d'injection des porteurs, ceci déterminant le contraste entre l'état allumé et l'état éteint d'un dispositif conforme à l'invention comportant ce milieu actif.

Si l'on utilise un faisceau lumineux pour commander ce dispositif, la fréquence v1 de ce faisceau lumineux (qui permet le pompage optique du milieu actif) est choisie de façon que h.v1 soit supérieure à Eg et supérieure à l'énergie hv des photons du faisceau à moduler.

Il est possible, en variant la composition des couches actives constituant le milieu actif, de choisir leur énergie de bande interdite Eg de telle sorte que Eg soit légèrement supérieure à l'énergie des photons de la lumière incidente.

On choisit par exemple Eg de l'ordre de h.v + 10meV ($\underline{h}$ représentant la constante de Planck).

Dans ce cas, $\underline{a}$ est de l'ordre de quelques centaines de cm$^{-1}$ lorsque le dispositif est au repos (D=0).

Lorsque les porteurs sont injectés en nombre suffisant dans le milieu actif, $\underline{a}$ devient négatif et l'on obtient un coefficient de gain par unité de longueur, noté g avec g=-a, qui atteint également une valeur de quelques centaines de cm$^{-1}$.

On réalise ainsi, toutes choses égales par ailleurs, un contraste entre l'état "éteint" et l'état "allumé" de quelques dizaines de dB.

Cependant, dans la même gamme spectrale entre e1 et e2 (voir la figure 7), l'indice de réfraction du milieu actif varie avec l'injection.

Ceci déplace la longueur d'onde de résonance de la cavité de Fabry-Perot et modifie donc également le contraste entre l'état "éteint" et l'état "allumé" à la longueur d'onde du faisceau d'entrée.

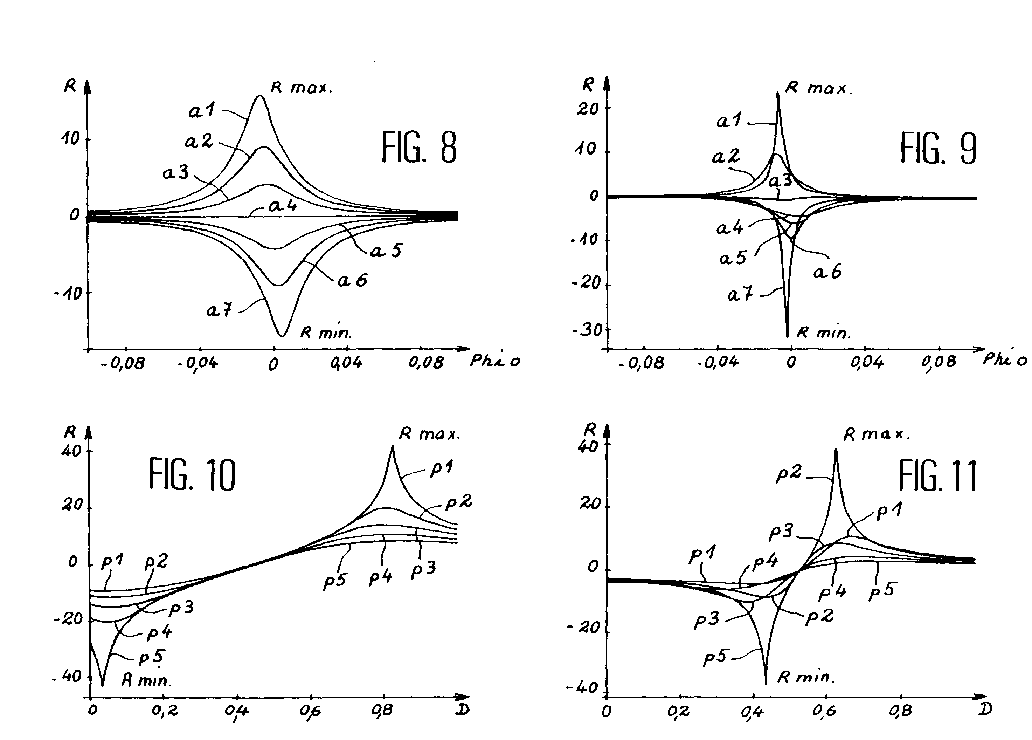

Les figures 8 à 11 illustrent cet effet dans un cas simple où $\underline{a}$ et $\underline{n}$ varient linéairement avec D dans l'équation (1).

La figure 8 montre les variations de la réflectivité R (exprimée en dB) en fonction de phio, phio étant égal à phi modulo pi pour D=0, en supposant R1 = 0,92 et R2 = 0,98 (>R1) et ce pour diverses valeurs de $\underline{a}$, à savoir : a1 = -0,04; a2 = -0,03; a3 = -0,02; a4 = -0,01; a5 = 0; a6 = 0,01; a7 = 0,02.

La figure 9 montre les variations de R (dB) en fonction de phio pour les diverses valeurs a1 à a7 du paramètre $\underline{a}$ mentionnées plus haut et dans le cas ou R1 est égal à 0,98 et R2 à 0,96 (<R1).

La figure 10 montre les variations de R(dB) en fonction de D lorsque R1 est égal à 0,92 et R2 à 0,98, pour diverses valeurs p1 à p5 de phio à savoir : p1 = -0,01; p2 = -0,006; p3 = -0,002; p4 = 0,002; p5 = 0,006.

La figure 11 montre les variations R (dB) en fonction de D lorsque R1 est égal à 0,98 et R2 à 0,96 pour les mêmes valeurs p1 à p5 du paramètre phio.

Pour maximiser le contraste, phio (et donc la longueur d'onde de fonctionnement $\underline{l}$) peut être choisi dans la plage comprise entre deux valeurs correspondant respectivement au maximum Rmax et au minimum Rmin de la réflectivité R qui sont indiqués sur les figures 8 et 9.

Pour poursuivre la discussion et illustrer quelques exemples d'utilisation de ce dispositif, plaçons-nous, pour fixer une origine, sur un mode de résonance de la cavité de Fabry-Perot, correspondant au cas$_2$ où phi est un multiple entier de pi (alors sin$^2$ (phi)=0).

Dans ces conditions, l'equation (1) se simplifie et l'on trouve deux points de fonctionnement intéressants du dispositif conforme à l'invention :

1° Ra prend la valeur R1 au cours du fonctionnement ; alors la réflectivité s'annule et l'on a une extinction parfaite.

Cette condition Ra=R1 est obtenue :

a) lorsque, en présence d'absorption, R1 est inférieur à R2 ; dans ce cas la réflectivité du dispositif de modulation est voisine de zéro (Rmin) en l'absence de porteurs injectés et elle augmente jusqu'à une valeur qui peut être supérieure à 1 (Rmax) lorsque $\underline{a}$ (qui dépend de D) devient négatif.

b) lorsque, en présence d'amplification, R1 est supérieur ou égale à R2 ; dans ce cas, la réflectivité du dispositif de modulation en l'absence de porteurs, bien qu'inférieure à 1, est en général supérieure à 50% ; par contre, lorsque $\underline{a}$ (fonction de D) diminue et devient négatif, la réflectivité du dispositif de modulation passe par un minimum voisin de zéro (Rmin), avant d'augmenter jusqu'à des valeurs supérieures à 1 (Rmax) ; la réflectivité différentielle dR/dD est donc plus élevée dans cette dernière configuration (voir les figures 10 et 11).

2° Ra prend la valeur 1 au cours du fonctionnement : la réflectivité du dispositif de modulation prend une valeur très élevée.

Cette condition ne peut être obtenue que dans le régime d'amplification.

Elle correspond à la condition de seuil de l'émission laser.

On voit donc qu'il est possible d'obtenir à la fois un très grand contraste de modulation ainsi qu'une amplification du signal modulé.

Pour rendre maximum le contraste de modulation il est avantageux de réaliser la condition Ra=R1 lorsque le milieu actif est un peu amplificateur.

Ceci a pour effet de minimiser le décalage de la condition de résonance dû à la variation d'indice de réfraction avec la densité de porteurs (voir la figure 9).

On peut même annuler ce décalage en concevant un dispositif conforme à l'invention dont les caractéristiques permettent de fonctionner au point de croisement des courbes I et II de la figure 7.

En ce qui concerne la bande passante de modulation d'un dispositif conforme à l'invention, il est possible d'obtenir une grande bande passante de modulation en utilisant ce dispositif dans une configuration où l'amplification par émission stimulée permet l'émission laser : à condition d'injecter les porteurs suffisamment rapidement (régime de "commutation de gain"), le gain dans la cavité peut atteindre une valeur supérieure à celle du régime stationnaire, mais pendant une période transitoire très courte (typiquement de l'ordre de quelques picosecondes).

Ensuite l'émission laser se produit sous la forme d'une impulsion très brève en raison de la durée extrêmement courte d'un aller-retour de la lumière dans la cavité de Fabry-Perot (durée de l'ordre de 20 à 40 femtosecondes)

A la fin de cette émission, le gain est considérablement diminué et se stabilise à une valeur que l'on note $g_0$.

A une échelle de temps plus longue, les porteurs résiduels se recombinent par émission spontanée et ce gain se transforme graduellement en absorption jusqu'à atteindre la valeur $a_0$ correspondant à D=0.

Dans ce cas où l'émission laser se produit, il convient d'utiliser le dispositif de modulation de telle façon que le faisceau laser produit ne se superpose pas au faisceau lumineux modulé.

On voit là l'intérêt d'une utilisation du dispositif sous incidence oblique.

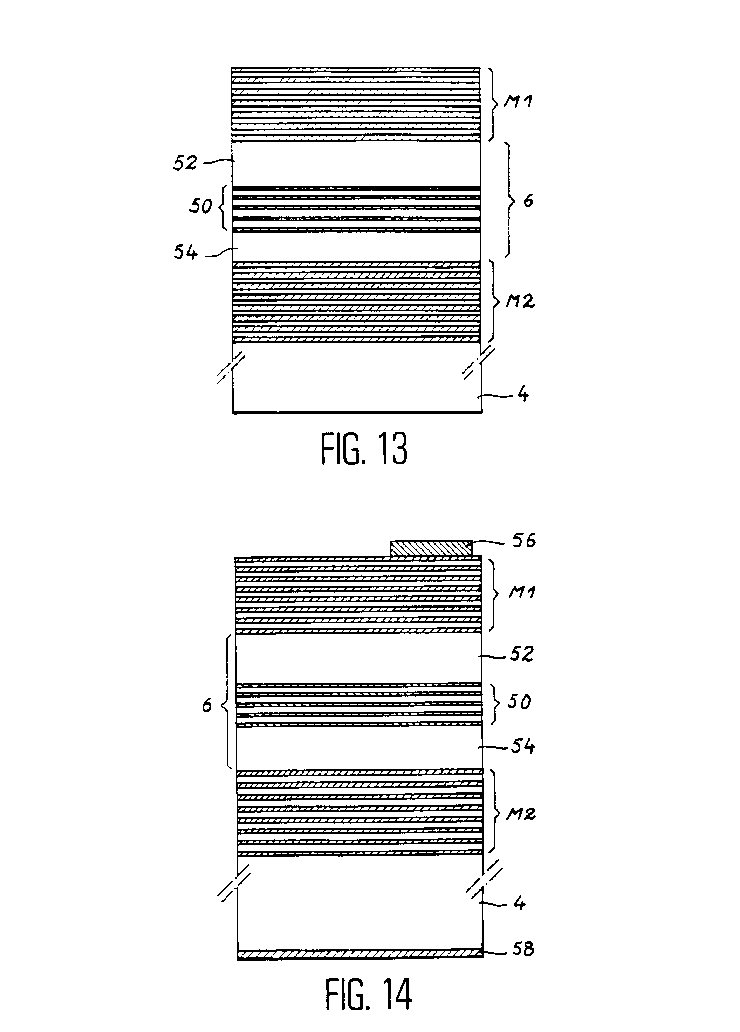

Ceci est schématiquement illustré par la figure 12 sur laquelle on a représenté partiellement un dispositif conforme à l'invention comprenant un milieu actif 6 entre deux miroirs M1 et M2.

Le substrat non représenté du dispositif est supposé transparent au faisceau d'entrée 8 qui est envoyé sous incidence oblique sur le miroir M2 dans l'exemple représenté sur la figure 12.

Un faisceau modulé 10 émerge du miroir M2 (sous un angle égal à l'angle d'incidence du faisceau 8) et un autre faisceau modulé 12 est disponible du côté du miroir M1 comme on le voit sur la figure 12.

Le dispositif émet également des faisceaux lasers 48 et 49 qui sont respectivement perpendiculaires aux miroirs M1 et M2 et ne sont donc pas superposés aux faisceaux modulés.

Pour la rapidité de fonctionnement du dispositif de modulation conforme à l'invention, il est également préférable que R1 soit supérieur ou égal à R2 (voir le cas 1°b) mentionné plus haut), de façon à obtenir une réflectivité différentielle élevée et par exemple obtenir une annulation de la réflectivité du dispositif dans le cas où le gain est stabilisé à la valeur $g_0$.

Pour cette rapidité de fonctionnement, il est également

ment préférable de faire fonctionner le dispositif en "mode polarisé", à savoir de lui appliquer soit un courant continu soit un faisceau optique d'intensité continue (suivant le type de commande du dispositif de modulation), de manière à établir un régime d'injection électrique ou de pompage optique stationnaire avec un gain stabilisé à la valeur $g_0$.

Le faisceau lumineux d'entrée est alors amplifié et modulé en superposant, à la fréquence de modulation desirée, une tension pulsée ou un faisceau optique pulsé qui réalise la commutation du gain dans la cavité et fait commuter le faisceau de sortie de l'état éteint à forte extinction à l'état allumé avec du gain.

Il est à noter que dans ce mode de fonctionnement ("mode polarisé") la commande pour le maintien de l'etat stationnaire avec le gain $g_0$ et la commande pour la commutation peuvent être une combinaison d'injection électrique et de pompage optique suivant l'application recherchée (c'est-à-dire que la commande pour le maintien de l'état stationnaire avec le gain $g_0$ peut être soit électrique soit optique et que la commande pour la commutation peut être soit électrique soit optique d'où quatre possibilités).

On a réalisé des expériences qui consistent à mesurer la réflectivité dans une configuration à deux faisceaux optiques pulsés (faisceau de pompage optique et faisceau que l'on veut moduler), avec des durées d'impulsion de 15 ps.

Ces expériences ont porté sur une structure de type Fabry-Perot dont la couche active est constituée de 130 puits quantiques GaAs/$Al_{0,7}$ $Ga_{0,3}$ As (10nm/10nm) insérés entre une paire de miroirs fabriqués par un empilement de Bragg GaAs/AlAs avec une réflectivité de 97,2% pour le miroir-arrière et de 91,7% pour le miroir-avant.

Cette cavité a une finesse de 15 et possède cinq modes espacés de 21 nm.

Cette structure a permis d'obtenir deux renseignements importants, l'un dans le domaine spectral et l'autre dans le domaine temporel.

En ce qui concerne le domaine spectral, quand on fixe la longueur d'onde du faisceau de pompage optique dans une gamme spectrale où le milieu actif est très absorbant (longueur d'onde de 785 nm) et que l'on fait varier la longueur d'onde du faisceau d'entrée (faisceau de sonde) de manière à balayer toutes les résonances de la cavité de Fabry-Perot (780nm à 880 nm), on observe pour une énergie de pompe de 5mJ/$cm^2$ (correspondant à une densité de porteurs de l'ordre de $10^{12}$ porteurs par $cm^2$ dans le milieu actif) une amplification de l'ordre de 8 dB sur la réflectivité de la sonde à chaque résonance de la cavité de Fabry-Perot.

Le facteur d'amplification dépend fortement de la densité des porteurs photo-excités.

En ce qui concerne le domaine temporel, l'introduction d'un retard variable (de -50 jusqu'à +200 ps) entre l'impulsion du faisceau de sonde et l'impulsion du faisceau de pompe montre que pour une énergie de pompe suffisante, l'amplification du faisceau de sonde réfléchi n'a lieu que pendant la durée de l'impulsion de pompe (15 ps), démontrant ainsi qu'un dispositif de modulation conforme à l'invention est capable de fonctionner à une fréquence de modulation supérieure à 10 GHz et n'est limité que par la durée de l'impulsion de pompe.

Dans la présente invention, la longueur d'onde d'utilisation (longueur d'onde du faisceau lumineux d'entrée) constitue un paramètre fondamental qui détermine le choix du matériau actif, la constitution des miroirs et la taille de la cavité de Fabry-Perot du dispositif.

Par ailleurs, une bonne connaissance des variations de a et n en fonction de D permet l'optimisation du dispositif du point de vue du gain et du taux d'injection.

Un dispositif conforme à l'invention peut être fabriqué à partir de tout matériau à condition que ce dernier puisse avoir du gain en régime d'injection électrique de porteurs ou de pompage optique.

Ceci est possible avec des verres dopés à l'aide de terres rares ou à l'aide de métaux de transition, avec des semiconducteurs etc.

De plus, la structure d'un tel dispositif peut être hybride ou monolithique en ce sens qu'elle peut être réalisée soit par le dépôt de couches minces de matériaux de natures différentes soit par épitaxie de couches minces de matériaux d'une même famille, soit par une combinaison des deux.

Des dispositifs conformes à l'invention peuvent en particulier être réalisés à partir de multicouches que l'on dépose par les techniques de croissance (M.B.E., C.B.E. ou M.O.C.V.D.) de couches minces de semi-conducteurs III-V, II-VI ou IV-IV, et que l'on "processe" ensuite par les techniques habituelles de fabrication de composants micro-optoélectroniques.

Ceci est parfaitement illustré par les deux exemples donnés ci-après.

Le premier exemple est schématiquement illustré par la figure 13 et porte sur un dispositif de modulation conforme à l'invention (modulateur-amplificateur) fonctionnant à 0,85 micromètre par pompage optique et en réflexion.

Dans cet exemple, le substrat 4 est en GaAs.

Le miroir M1, le plus éloigné du substrat, est un miroir de Bragg composé de m couches quart d'onde (l'épaisseur d'une couche est égale à l/(4.n) où l est la longueur d'onde du faisceau d'entrée et n la partie réelle de l'indice de réfraction complexe du matériau constitutif de cette couche) en GaAs qui alternent avec m couches quart d'onde en AlAs, d'où m périodes GaAs/AlAs.

Le miroir M2, qui repose sur le substrat 4, est un miroir de Bragg composé de m couches quart d'onde en GaAs qui alternent avec m couches quart d'onde en AlAs.

Le nombre m peut être compris entre 5 et 25 et peut être différent d'un miroir à l'autre suivant la dissymétrie recherchée entre les deux miroirs M1 et M2.

Entre ces miroirs M1 et M2 on trouve le milieu actif 6 composé d'une structure à multipuits quantiques GaAs/GaAlAs portant la référence 50, cette structure comportant ainsi des couches-barrière en AlGaAs.

Cette structure à multipuits quantiques est insérée entre deux couches tampons en GaAlAs référencées 52 et 54.

L'épaisseur des puits et des barrières de la structure à multipuits quantiques est de 10nm.

L'épaisseur de la cavité ainsi obtenue est déterminée par la longueur d'onde de fonctionnement.

L'empilement des couches constituant les miroirs et le milieu actif est réalisé par épitaxie sur le substrat 4 soit par MBE soit par MOCVD.

Le miroir-avant M1 peut être éventuellement remplacé soit par une multicouche diélectrique soit par une couche métallique très mince de façon qu'elle soit partiellement transparente au faisceau incident.

Le deuxième exemple est schématiquement illustré par la figure 14 et porte sur un dispositif de modulation conforme à l'invention fonctionnant à 0,85 micromètre par injection électrique et en réflexion.

Ce dispositif est réalisé comme celui de la figure 13, à ceci près que les miroirs M1 et M2 sont dopés au cours de la croissance dans le cas de la figure 14.

A titre d'exemple, pour un substrat 4 en GaAs de type N, le dopage du miroir M1 est de type P et le dopage du miroir M2 est de type N.

Toujours dans le cadre de la figure 14, la zone 50 contenant les puits quantiques est intrinsèque mais les zones tampons 52 et 54 qui sont situées de part et d'autre de cette zone 50 sont dopées de la même manière que les miroirs adjacents : la zone tampon 52 est dopée P comme le miroir M1 et la zone tampon 54 est dopée N comme le miroir M2.

Le dispositif de la figure 14 comprend également des contacts électriques 56 et 58 prévus pour la polarisation de façon directe du dispositif par des moyens appropriés, comme on l'a expliqué plus haut.

Comme on le voit sur la figure 14, le contact électrique 56, qui est situé sur le miroir M1, est placé sur un bord du dispositif de manière à ne pas gêner les faisceaux d'entrée et de sortie.

Dans l'exemple représenté sur la figure 14, le contact électrique 58 est formé sur la face arrière du substrat 4 (face opposée à celle qui porte le miroir M2).

Ces contacts électriques sont réalisés par les technologies habituelles de dépôts de métaux pour contacts ohmiques N et P sur les semiconducteurs III-V.

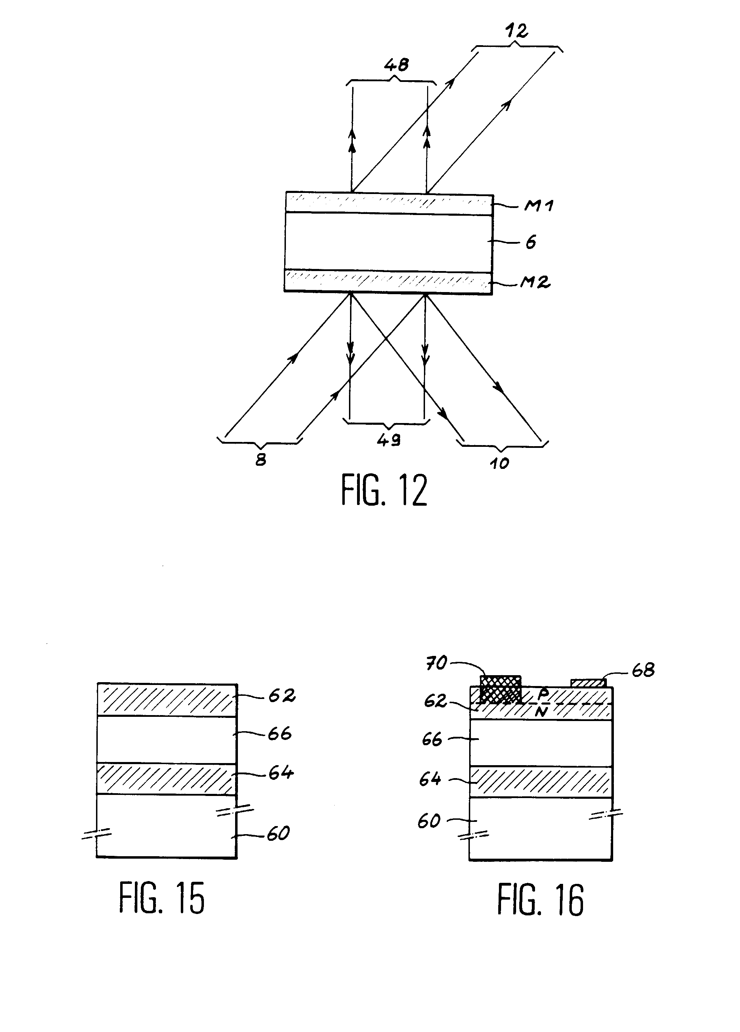

Les figures 15 et 16 illustrent schématiquement d'autres dispositifs conformes à l'invention dans lesquels le milieu actif se trouve dans l'un des deux miroirs de la cavité de Fabry-Perot que comportent ces dispositifs ou dans ces deux miroirs.

Le dispositif de la figure 15 est à commande optique et comprend, sur un substrat semiconducteur 60, deux miroirs de Bragg multicouches 62 et 64.

Pour l'un de ces miroirs 62 ou 64 ou pour les deux miroirs, toutes les couches constitutives, ou une couche sur deux, permettent par pompage optique une émission stimulée et donc une amplification optique à la longueur d'onde du faisceau d'entrée.

Entre les deux miroirs de Bragg 62 et 64, se trouve un matériau passif c'est-à-dire un matériau qui ne donne pas lieu à l'émission stimulée dans les conditions d'utilisation.

La figure 16 illustre schématiquement un dispositif conforme à l'invention dont la commande est électrique.

Ce dispositif a la même structure que celui de la figure 15 mais, dans le dispositif de la figure 16, une jonction P-N est en outre formée dans celui des miroirs 62 et 64 qui contient le milieu actif, le miroir 62 dans l'exemple représenté : ce miroir 62 comporte une zone dopée N et une zone dopée P avec éventuellement une zone intrinsèque (non représentée) entre ces deux zones.

Des électrodes 68 et 70 sont respectivement prévues sur le miroir 62 pour pouvoir contacter les zones P et N et pour polariser cette jonction P-N de façon directe.

Si le milieu actif se trouve dans les deux miroirs 62 et 64, chacun de ceux-ci doit comporter une jonction P-N.

Chaque jonction P-N est à polariser de façon directe, le dispositif étant muni d'électrodes permettant ces polarisations directes.

DOCUMENTS CITES

(1) Special issue on semiconductor lasers : vertical cavity Surface-Emitting Lasers., IEEE Journal Quantum Electronics, Vol.27, n°6, p.1332-1417

(2) Optically controlled surface-emitting lasers, W. K. Chou, J.P. Harbison, A.C. Von Lehmen, L.T. florez, C.K. Nguyen, S.A. Sharz, Appl. Phys. Lett. 58 2342 (1991)

(3) Surface-emitting laser operation in vertical-to-surface transmission electrophotonic device with a vertical cavity, T. Numai, M. Sugimoto, I. Ogura, H. Kosaka, K. Kasahara, Appl. Phys. Lett. 58 1250 (1991)

(4) High contrast multiple quantum well optical bistable device with integrated Bragg reflectors, B.G. Sfez, J.L. Oudar, J.C. Michel, R. Kuszelewicz, R. Azoulay, Appl. Phys. Lett. 57, 334 (1990)

(5) Electro absorption and refraction in Fabry-Perot quantum well modulators : a general discussion, G. D. Boyd, G. Luvescu, Optical and Quantum Electronics 24 147 (1992)

(6) Optically addressed asymmetric Fabry-Perot modulator, A. Larsson, J. Maserjian, Appl. Phys. Lett. 59 (24) 3099 (1991)

(7) All-optical photonic switches using integrated inverted asymmetric Fabry-Perot modulators and heterojunction phototransistors, Kezhong Hu, Li Chen, Kian Kaviani, Ping Chen, Anupam Madhukar, IEEE Photon. Technol. Lett. 4 263 (1992)

(8) Amplifier modulation integrated with a cleaved-coupled-cavity injection laser, T.P. Lee et al., Elect. Lett. 20(15) 625 (1985)

(9) Gain characteristic of a 1.5 um nonlinear split contact laser amplifier, I.W. Marshall et al., Appl. Phys. Lett. 53, 1577 (1988)

(10) Simplified calculation of the optical spectra of two and three dimensional laser excited semiconductors, C. Ell et al., J. Opt. Soc. Am. Vol.6 (11) 2006 (1988)

## Revendications

1. Procédé de modulation d'au moins un faisceau lumineux, procédé selon lequel on envoie au moins un faisceau lumineux d'entrée (8, 8a; 32; 36, 38, 40) sur au moins un résonateur vertical de type Fabry-Perot (2) ayant au moins un mode de résonance, délimité par deux miroirs (M1, M2) et réalisé par empilement de couches sur un substrat (4, 30), au moins l'une de ces couches formant un milieu actif (6), procédé caractérisé en ce que ce milieu actif est apte à amplifier, par émission stimulée, ce ou ces faisceaux lumineux d'entrée, la longueur d'onde de chaque faisceau lumineux d'entrée étant autour de la résonance du résonateur de Fabry-Perot, le ou les faisceaux d'entrée accédant au résonateur Fabry-Perot par l'un des deux miroirs (M1, M2), et en ce qu'on fait varier la densité de porteurs de charge libres dans le milieu actif de manière à rendre ce milieu actif tantôt absorbant tantôt amplificateur vis-à-vis du ou des faisceaux lumineux d'entrée et à obtenir ainsi au moins un faisceau lumineux de sortie (9, 9a; 10, 12; 42, 44, 46) dont l'intensité est modulée et amplifiée par rapport à chaque faisceau d'entrée.

2. Procédé selon la revendication 1, caractérisé en ce que la cavité est multimode et en ce qu'on utilise une pluralité de faisceaux d'entrée de longueur d'onde différentes, chaque longueur d'onde étant choisie autour de l'une des résonances de la cavité.

3. Procédé selon l'une quelconque des revendications 1 et 2, caractérisé en ce que l'empilement de couches inclut au moins une jonction P-N et en ce qu'on polarise celle-ci de façon directe tout en faisant varier cette polarisation de manière à injecter des porteurs de charge libres et obtenir la variation de la densité de porteurs de charge libres dans le milieu actif (6).

4. Procédé selon l'une quelconque des revendications 1 et 2, caractérisé en ce qu'on envoie en outre un faisceau lumineux de commande (24) dans le milieu actif (6), ce faisceau lumineux de commande étant apte à être absorbé par ce milieu actif et à réaliser un pompage optique dans ce dernier, et en ce qu'on fait varier l'intensité du faisceau lumineux de commande de manière à obtenir la variation de la densité de porteurs de charge libres dans le milieu actif.

5. Procédé selon l'une quelconque des revendications 1 à 4, caractérisé en ce que la longueur d'onde de chaque faisceau d'entrée correspond à la résonance de la cavité dans l'état éteint.

6. Procédé selon l'une quelconque des revendications 1 à 4, caractérisé en ce que la longueur d'onde de chaque faisceau d'entrée correspond à la résonance de la cavité dans l'état allumé.

7. Procédé selon l'une quelconque des revendications 1 et 2, caractérisé en ce qu'on établit dans le milieu actif (6) un régime d'injection électrique ou de pompage optique stationnaire, et en ce qu'on agit simultanément sur le milieu actif de manière à réaliser une commutation de gain pour obtenir la modulation du ou des faisceaux lumineux de sortie (10, 12; 42, 44, 46).

8. Procédé selon l'une quelconque des revendications 1 à 7, caractérisé en ce que le milieu actif (6) est excité de manière à obtenir une émission laser (48, 49) de sa part.

9. Procédé selon l'une quelconque des revendications 1 à 8, caractérisé en ce que chaque faisceau lumineux d'entrée (8) a un angle d'incidence non nul sur l'un des miroirs du résonateur.

10. Procédé selon l'une quelconque des revendications 1 à 9, caractérisé en ce qu'on envoie une pluralité de faisceaux lumineux d'entrée (8, 8a; 32, 36, 38, 40) sur le résonateur, ces faisceaux lumineux d'entrée ayant des directions d'incidence différentes sur l'un des miroirs du résonateur et ayant des longueurs d'onde identiques ou différentes, chaque longueur d'onde étant choisie soit autour d'une même résonance de la cavité soit autour de différentes résonances de la cavité si celle-ci est multimode, ce qui permet d'appliquer la même modulation à cette pluralité de faisceaux qui seront distingués soit par leur direction de sortie soit par leur longueur d'onde.

11. Procédé selon l'une quelconque des revendications 1 10, caractérisé en ce qu'on envoie une pluralité de faisceaux d'entrée respectivement sur une pluralité de résonateurs de Fabry-Perot formant un réseau bidimensionnel sur un même substrat, de manière à obtenir une pluralité de faisceaux de sortie modulés et amplifiés.

12. Dispositif de modulation d'au moins un faisceau lumineux, comprenant :

- au moins un résonateur vertical de type Fabry-Perot ayant au moins un mode de résonance, délimité par deux miroirs (M1, M2) et réalisé par empilement de couches sur un substrat (4),
- un milieu actif qui se trouve dans l'un au moins des miroirs (M1, M2) du résonateur ou qui est formé par au moins l'une des couches entre les deux miroirs,

caractérisé en ce que le milieu actif (6) est apte à amplifier, par émission stimulée, au moins un faisceau lumineux d'entrée (8, 8a; 32; 36, 38, 40), la longueur d'onde de chaque faisceau lumineux d'entrée étant autour de la résonance du résonateur de Fabry-Perot, le ou les faisceaux d'entrée accédant au résonateur Fabry-Perot par l'un des deux miroirs (M1, M2), et

- des moyens (18, 26) prévus pour faire varier la densité de porteurs de charge libres dans le milieu actif de manière à rendre ce milieu actif tantôt absorbant tantôt amplificateur vis-à-vis du ou des faisceaux lumineux d'entrée et à obtenir ainsi au moins un faisceau lumineux de sortie (9, 9a; 10, 12; 42, 44, 46) dont l'intensité est modulée et amplifiée par rapport à chaque faisceau d'entrée.

13. Dispositif selon la revendication 12, caractérisé en ce que le milieu actif (6) se trouve entre les deux miroirs (M1, M2) du résonateur, en ce que le dispositif comporte au moins une jonction P-N et en ce que les moyens prévus pour faire varier la densité de porteurs de charge libres dans le milieu actif sont des moyens aptes à polariser de façon directe cette jonction et à faire varier cette polarisation de façon à obtenir la modulation du ou des faisceaux de sortie (9, 9a; 10, 12; 42, 44, 46).

14. Dispositif selon l'une quelconque des revendications 12 et 13, caractérisé en ce que le substrat (4) est transparent à chaque faisceau lumineux d'entrée (8; 36, 38, 40), de sorte que le dispositif est utilisable en transmission ou en réflexion à travers le substrat.

15. Dispositif selon l'une quelconque des revendications 12 et 13, caractérisé en ce que le substrat comporte au moins une ouverture délimitant un modulateur élémentaire.

16. Dispositif selon l'une quelconque des revendications 12 et 13, caractérisé en ce que le même miroir (M1) constitue la face d'entrée du ou des faisceaux lumineux d'entrée (8; 36, 38, 40) ainsi que la face de sortie du ou des faisceaux lumineux de sortie (10; 42, 44, 46), le dispositif fonctionnant ainsi en réflexion.

17. Dispositif selon la revendication 16, caractérisé en ce que la réflectivité du miroir (M1) qui constitue la face d'entrée du ou des faisceaux lumineux d'entrée ainsi que la face de sortie du ou des faisceaux lumineux de sortie est inférieure à la réflectivité de l'autre miroir (M2) du dispositif.

18. Dispositif selon la revendication 16, caractérisé en ce que la réflectivité du miroir (M1) qui constitue la face d'entrée du ou des faisceaux lumineux d'entrée ainsi que la face de sortie du ou des faisceaux lumineux de sortie est supérieure ou égale à la réflectivité de l'autre miroir (M2) du dispositif.

19. Dispositif selon l'une quelconque des revendications 12 à 16, caractérisé en ce que le résonateur est conçu pour obtenir l'émission laser.

20. Dispositif selon l'une quelconque des revendications 12 à 19, caractérisé en ce qu'il comprend une pluralité de résonateurs de type Fabry-Perot, formant un réseau bidimensionnel sur un même substrat (30).

21. Dispositif selon l'une quelconque des revendications 12 à 20, caractérisé en ce qu'il est réalisé à partir de matériaux III-V.

22. Dispositif selon l'une quelconque des revendications 12 à 20 caractérisé en ce que l'un au moins des miroirs est une multicouche diélectrique.

**Patentansprüche**

1. Verfahren zur Modulation von mindestens einem Lichtstrahl, gemäß welchem mindestens ein Eingangslichtstrahl (8, 8a; 32; 36, 38, 40) auf mindestens einen vertikalen Fabry-Perot-Resonator (2) gegeben wird, der mindestens eine Resonanzmode aufweist, durch zwei Spiegel (M1, M2) begrenzt ist und durch Aufstapelung von Schichten auf einem Substrast (4, 30) gebildet ist, wobei mindestens eine dieser Schichten ein aktives Medium (6) bildet, dadurch gekennzeichnet, daß das aktive Medium geeignet ist, durch stimulierte Emission den oder die Eingangslichtstrahl(en) zu verstärken, wobei die Wellenlänge jedes Eingangslichtstrahls um die Resonanz des Fabry-Perot-Resonators liegt, der oder die Eingangslichtstrahl(en) den Fabry-Perot-Resonator durch einen der zwei Spiegel (M1, M2) betritt, und daß die Dichte der freien Ladungsträger in dem aktiven Medium in der Weise variiert wird, daß das aktive Medium bald absorbierend, bald verstärkend in Bezug auf die Eingangslichtstrahlen wird und mindestens ein Ausgangslichtstrahl (9, 9a; 10, 12; 42, 44, 46) erhalten wird, dessen Intensität moduliert und verstärkt ist in Bezug auf jeden Eingangslichtstrahl.

2. Verfahren nach Anspruch 1, dadurch gekennzeichnet, daß der Hohlraum multimodal ist und daß eine Anzahl von Eingangslichtstrahlen mit verschiedenen Wellenlängen verwendet wird, wobei jede Wellenlänge um eine der Resonanzen des Hohlraums gewählt ist.

3. Verfahren nach einem der Ansprüche 1 oder 2, dadurch gekennzeichnet, daß die Aufstapelung der Schichten mindestens eine P-N-Verbindung umfaßt und daß diese in direkter Weise polarisiert ist, wobei diese Polarisation in der Weise variiert wird, daß freie Ladungsträger eingeführt werden, und eine Variation der Dichte der freien Ladungsträger in dem aktiven Medium (6) erhalten wird.

4. Verfahren nach einem der Ansprüche 1 oder 2, dadurch gekennzeichnet, daß weiterhin ein Steuerlichtstrahl (24) in das aktive Medium (6) gegeben wird, wobei dieser Steuerlichtstrahl geeignet ist, in diesem aktiven Medium absorbiert zu werden und ein optisches Pumpen in dem letzteren bewirkt, und daß die Intensität des Steuerlichtstrahls in der Weise variiert wird, daß die Variation der Dichte der freien Ladungsträger in dem aktiven Medium erreichen wird.

5. Verfahren nach einem der Ansprüche 1 bis 4, dadurch gekennzeichnet, daß die Wellenlänge jedes Eingangslichtstrahls der Resonanz des Hohlraums im gelöschten Zustand entspricht.

6. Verfahren nach einem der Ansprüche 1 bis 4, dadurch gekennzeichnet, daß die Wellenlänge jedes Eingangslichtstrahls der Resonanz des Hohlraums im angezündeten Zustand entspricht.

7. Verfahren nach einem der Ansprüche 1 oder 2, dadurch gekennzeichnet, daß in dem aktiven Medium (6) ein Bereich der elektrischen Injektion oder des stationären optischen Pumpens eingerichtet wird, und daß auf das aktive Medium gleichzeitig in der Weise eingewirkt, daß eine Umschaltung des Gain bewirkt wird, um die Modulation des oder der Eingangslichtstrahl(en) (10, 12; 42, 44, 46) zu erhalten.

8. Verfahren nach einem der Ansprüche 1 bis 7, dadurch gekennzeichnet, daß das aktive Medium (6) in der Weise angeregt wird, daß von dort eine Laseremission (48, 49) erhalten wird.

9. Verfahren nach einem der Ansprüche 1 bis 8, dadurch gekennzeichnet, daß jeder Eingangslichtstrahl (8) einen von Null verschiedenen Einfallswinkel auf einen der Resonatorspiegel aufweist.

10. Verfahren nach einem der Ansprüche 1 bis 9, dadurch gekennzeichnet, daß eine Anzahl von Eingangslichtstrahlen (8, 8a; 32, 36, 38, 40) auf den Resonator gegeben wird, wobei die Eingangslichtstrahlen verschiedene Einfallsrichtungen auf einen der Resonatorspiegel aufweisen und identische oder verschiedene Wellenlängen aufweisen, wobei jede Wellenlänge entweder um die gleiche Resonanz des Hohlraums oder um verschiedene Resonanzen des Hohlraums, falls dieser multimodal ist, gewählt ist, was die Anwendung der gleichen Modulation auf diese Anzahl von Lichtstrahlen erlaubt, welche sich entweder durch ihre Ausgangsrichtung oder durch ihre Wellenlänge unterscheiden.

11. Verfahren nach einem der Ansprüche 1 bis 10, dadurch gekennzeichnet, daß eine Anzahl von Eingangslichtstrahlen jeweils auf eine Anzahl von Fabry-Perot-Resonatoren gegeben wird, die ein zweidimensionales Netz auf einem Substrat bilden, in der Weise, daß eine Anzahl von modulierten und verstärkten Ausgangslichtstrahlen erhalten wird.

12. Vorrichtung zur Modulation von mindestens einem Lichtstrahl, umfassend:

   - mindestens einen vertikalen Fabry-Perot-Resonator mit mindestens einer Resonanzmode, begrenzt durch zwei Spiegel (M1, M2) und ausgeführt durch Aufstapelung von Schichten auf einem Substrat (4),
   - ein aktives Medium, das sich in mindestens einer der Spiegel (M1, M2) des Resonators befindet oder das mindestens durch eine der Schichten zwischen den Spiegeln gebildet wird,
   - dadurch gekennzeichnet, daß das aktive Medium (6) geeignet ist, durch stimulierte Emission mindestens einen Eingangslichtstrahl (8, 8a; 32; 36, 38, 40) zu verstärken, wobei die Wellenlänge jedes Eingangslichtstrahls um die Resonanz des Fabry-Perot-Resonators liegt, wobei der oder die Eingangslichtstrahl(en) den Fabry-Perot-Resonator durch einen der zwei Spiegel (M1, M2) betritt, und daß
   - eine Einrichtung (18, 26) vorgesehen ist, um die Dichte der freien Ladungsträger in dem aktiven Medium in der Weise zu ändern, daß das aktive Medium bald absorbierend, bald verstärkend wird in Hinsicht auf den oder die Eingangslichtstrahl(en) und mindestens ein Ausgangslichtstrahl (9, 9a; 10, 12; 42, 44, 46) erhalten wird, dessen Intensität moduliert und verstärkt ist in Bezug auf jeden Eingangslichtstrahl.

13. Vorrichtung nach Anspruch 12, dadurch gekennzeichnet, daß das aktive Medium (6) sich zwischen den zwei Spiegeln (M1, M2) des Resonators befindet, und daß die Vorrichtung mindestens eine P-N-Verbindung umfaßt und daß die Einrichtung, die vorgesehen ist, um die Dichte der freien Ladungsträger in dem aktiven Medium zu variieren, eine Einrichtung ist, um in direkter Weise diese Verbindung zu polarisieren und um diese Polarisation in der Weise zu variieren, daß die Modulation von dem oder den Ausgangslichtstrahl(en) (9, 9a; 10, 12, 42, 44, 46) erreicht wird.

14. Vorrichtung nach einem der Ansprüche 12 oder 13, dadurch gekennzeichnet, daß das Substrat (4) transparent ist für jeden Eingangslichtstrahl (8; 36, 38, 40), in der Weise, daß die Vorrichtung in Transmission oder Reflexion durch das Substrat verwendbar ist.

15. Vorrichtung nach einem der Ansprüche 12 oder 13, dadurch gekennzeichnet, daß das Substrat mindestens eine Öffnung aufweist, die einen Elementarmodulator begrenzt.

16. Vorrichtung nach einem der Ansprüche 12 oder 13, dadurch gekennzeichnet, daß derselbe Spiegel (M1) die Eingangsfläche von dem oder den Eingangslichtstrahl(en) (8; 36, 38, 40) und die Ausgangsfläche von dem oder den Ausgangslichtstrahl (en) (10; 42, 44, 46) bildet, wobei die Vorrichtung in Reflexion arbeitet.

17. Vorrichtung nach Anspruch 16, dadurch gekennzeichnet, daß die Reflektivität des Spiegels (M1), der die Eingangsfläche von dem oder den Eingangslichtstrahl(en) und die Ausgangsfläche von dem oder den Ausgangslichtstrahl(en) bildet, kleiner ist als die Reflektivität des anderen Spiegels (M2) der Vorrichtung.

18. Vorrichtung nach Anspruch 16, dadurch gekennzeichnet, daß die Reflektivität des Spiegels (M1), der die Eingangsfläche von dem oder den Eingangslichtstrahl(en) und die Ausgangsfläche von dem oder den Ausgangslichtstrahl(en) bildet, größer oder gleich der Reflektivität des anderen Spiegels (M2) der Vorrichtung ist.

19. Vorrichtung nach einem der vorangegangenen Ansprüche 12 bis 16, dadurch gekennzeichnet, daß der Resonator vorgesehen ist, um eine Laseremission zu erhalten.

20. Vorrichtung nach einem der Ansprüche 12 bis 19, dadurch gekennzeichnet, daß er eine Anzahl von Fabry-Perot-Resonatoren umfaßt, die ein zweidimensionales Netz auf einem Substrat (30) bilden.

21. Vorrichtung nach einem der Ansprüche 12 bis 20, dadurch gekennzeichnet, daß er auf der Basis von Materialien III-V ausgeführt ist.

22. Vorrichtung nach einem der Ansprüche 12 bis 20, dadurch gekennzeichnet, daß mindestens einer der Spiegel eine dielektrische Multischicht ist.

## Claims

1. Process for the modulation of at least one light beam, according to which at least one input light beam (8, 8a; 32; 36, 38, 40) is supplied to at least one vertical Fabry-Perot resonator (2) having at least one resonance mode, defined by two mirrors (M1, M2) and produced by the stacking of layers on a substrate (4, 30), at least one of these layers forming an active medium,(6), characterized in that the active medium is able to amplify by stimulated emission said input light beam or beams, the wavelength of each input light beam being around the resonance of the Fabry-Perot resonator the input beam (s) accessing the Fabry-Perot resonator by one of the two mirrors (M1, M2) and in that the density of the free charge carriers in the active medium is varied so as to make said active medium sometimes absorbent and sometimes amplifying with respect to the input light beam or beams so as in this way to obtain at least one output light beam (9, 9a; 10, 12; 42, 44, 46), whose intensity is modulated and amplified relative to each input beam.

2. Process according to claim 1, characterized in that the cavity is multimodal and in that use is made of a plurality of input beams of different wavelengths, each wavelength being chosen around one of the resonances of the cavity.

3. Process according to either of the claims 1 and 2, characterized in that the stack of layers includes at least one P-N junction and in that the latter is directly polarized whilst varying said polarization in such a way as to inject free charge carriers and obtain the variation of the density of the free charge carriers in the active medium (6).

4. Process according to either of the claims 1 and 2, characterized in that a control light beam (24) is also fed into the active medium (6), said control light beam being absorbable by said active medium and appropriate for carrying out an optical pumping in the latter and in that the intensity of the control light beam is varied so as to bring about the variation of the density of the free charge carriers in the active medium.

5. Process according to any one of the claims 1 to 4, characterized in that the wavelength of each input beam corresponds to the resonance of the cavity in the off state.

6. Process according to any one of the claims 1 to 4, characterized in that the wavelength of each input beam corresponds to the resonance of the cavity in the on state.

7. Process according to either of the claims 1 and 2, characterized in that in the active medium (6) is established an electrical injection or stationary optical pumping regime and in that simultaneous action takes place on the active medium so as to bring about a gain switching for obtaining the modulation of the output light beam(s) (10, 12; 42, 44, 46).

8. Process according to any one of the claims 1 to 7, characterized in that the active medium (6) is excited so as to bring about a laser emission (48, 49).

9. Process according to any one of the claims 1 to 8, characterized in that each input light beam (8) has a non-zero incidence angle on one of the resonator mirrors.

10. Process according to any one of the claims 1 to 9, characterized in that a plurality of input light beams (8, 8a; 32, 36, 38, 40) is supplied to the resonator, said input light beams having different incidence directions on one of the resonator mirrors and identical or different wavelengths, each wavelength being chosen either around the same resonance of the cavity or around different resonances of the cavity if the latter is multimodal, which makes it possible to apply the same modulation to said plurality of beams, which would be distinguished either by their output direction or by their wavelength.

11. Process according to any one of the claims 1 to 10, characterized in that a plurality of input beams is supplied respectively to a plurality of Fabry-Perot resonators forming a bidimensional array on the same substrate, so as to obtain a plurality of modulated, amplified output beams.

12. Apparatus for the modulation of at least one light beam, comprising at least one vertical Fabry-Perot resonator having at least one resonance mode, defined by two mirrors (M1, M2) and produced by stacking layers on a substrate (4), an active medium located in at least one of the mirrors (M1, M2) of the resonator or which is formed by at least one of the layers between the two mirrors, characterized in that the active medium (6) is able to amplify by stimulated emission at least one input light beam (8, 8a; 32, 36, 38, 40), the wavelength of each input light beam being around the resonance of the Fabry-Perot resonator, the input beam or beams accessing the Fabry-Perot resonator by one of the two mirrors (M1, M2) and means (18, 26) for varying the density of the free charge carriers in the active medium, so as to make said active medium sometimes absorbent and sometimes amplifying with respect to the input light beam or beams and in this way obtain at least one output light beam (9, 9a; 10, 12; 42, 44, 46), whose intensity is modulated and amplified relative to each input beam.

13. Apparatus according to claim 12, characterized in that the active medium (6) is located between the two resonator mirrors (M1, M2), in that the apparatus has at least one P-N junction and that the means provided for varying the density of the free charge carriers in the active medium are means able to directly polarize said junction and vary said polarization in such a way as to obtain the modulation of the output beam(s) (9, 9a; 10, 12; 42, 44, 46).

14. Apparatus according to either of the claims 12 and 13, characterized in that the substrate (4) is transparent to each input light beam (8; 36, 38, 40) so that the apparatus is usable in transmission or in reflection through the substrate.

15. Apparatus according to either of the claims 12 and 13, characterized in that the substrate has at least one opening defining an elementary modulator.

16. Apparatus according to either of the claims 12 and 13, characterized in that the same mirror (M1) constitutes the input face of the input light beam(s) (8; 36, 38, 40), as well as the output face of the output light beam(s) (10; 42, 44, 46), so that the apparatus operates in reflection.

17. Apparatus according to claim 16, characterized in that the reflectivity of the mirror (M1), which constitutes the input face of the input light beam or beams, as well as the output face of the output light beam or beams, is below the reflectivity of the other mirror (M2) of the apparatus.

18. Apparatus according to claim 16, characterized in that the reflectivity of said mirror (M1), which constitutes the input face of the input light beam or beams, as well as the output face of the output light beam or beams, is equal to or greater than the reflectivity of the other mirror (M2) of the apparatus.

19. Apparatus according to any one of the claims 12 to 16, characterized in that the resonator is designed so as to obtain the laser emission.

20. Apparatus according to any one of the claims 12 to 19, characterized in that it comprises a plurality of Fabry-Perot resonators forming a bidimensional array on the same substrate (30).

21. Apparatus according to any one of the claims 12 to 20, characterized in that it is made from III-V materials.

22. Apparatus according to any one of the claims 12 to 20, characterized in that at least one of the mirrors is a dielectric multilayer.

FIG. 1

FIG. 2

FIG. 3

FIG. 5

FIG. 4

FIG. 5 A

FIG. 5 B

FIG. 6

FIG. 7

FIG. 8

FIG. 9

FIG. 10

FIG. 11

EP 0 575 227 B1

FIG. 13

FIG. 14

FIG. 12

FIG. 15

FIG. 16